# EUROPÄISCHE PATENTANMELDUNG

(11) **EP 2 813 783 A1**
(43) Veröffentlichungstag der Anmeldung: **17.12.2014**
(21) Anmeldenummer: 13171662.3
(22) Anmeldetag: 12.06.2013
(51) Int. Cl.: F24J 2/52

(54) **Ständer zum Abstützen von Solarpaneelen auf einem Flachdach**

(71) Anmelder: HILTI Aktiengesellschaft, 9494 Schaan (LI)
(72) Erfinder: Bragagna, Elio, 6822 Duens (AT); Trebo, Berndt, 6972 Fussach (AT); Schwerdtfeger, Klaus, 6800 Feldkirch-Gisingen (AT); Schreiber, Gerald, 6800 Feldkirch (AT)
(74) Vertreter: Hilti Aktiengesellschaft Corporate Intellectual Property

(57) **Zusammenfassung**

Die Erfindung betrifft einen Ständer zum Abstützen von Solarpaneelen auf einem Flachdach, mit einem Fussteil, welches eine Grundplatte zur Auflage auf dem Flachdach aufweist, und einem Kopfteil, welches einen Auflagebereich für Solarpaneele aufweist, wobei das Kopfteil und das Fussteil zwei separate Teile sind. Erfindungsgemäss ist vorgesehen, dass das Fussteil integrale Riegelleisten und das Kopfteil integrale Riegelleisten aufweist, wobei die Riegelleisten das Kopfteil und das Fussteil formschlüssig miteinander verbinden.

## Beschreibung

Die Erfindung betrifft einen Ständer zum Abstützen von Solarpaneelen auf einem Flachdach, gemäss dem Oberbegriff des Anspruchs 1. Ein solcher Ständer ist ausgeführt mit einem Fussteil, welches eine Grundplatte zur Auflage auf dem Flachdach aufweist, und einem Kopfteil, welches einen Auflagebereich für Solarpaneele aufweist, wobei das Kopfteil und das Fussteil zwei separate Teile sind.

Ein gattungsgemässer Ständer geht aus der EP 2416084 A2 hervor. Dort wird ein als Gussteil ausgeführter Montagefuss beschrieben, der auf einem Gleitschuh aufsteht.

Eine weitere Solaranordnung mit Stützelementen ist aus der WO 12012998 A1 bekannt. Diese Schrift lehrt, mehrteilige Stützelemente über Zusatzelemente zu verbinden. Bei den Zusatzelementen könnte es sich beispielsweise um Nutensteine handeln.

Weitere Stützelemente für Solaranordnungen sind aus der DE 202008007549 U1, WO 11160851 A1, EP 2525165A1, EP 2525166 A1, DE 102011007521 A1, WO 12095195 A2, DE 202010015817 U1, WO 09120923 A2 und WO 12041827 A1 bekannt.

Aufgabe der Erfindung ist es, einen Ständer für Solaranordnungen anzugeben, der bei besonders geringem Material- und Herstellungsaufwand besonders einfach zu installieren und zuverlässig im Betrieb ist.

Die Aufgabe wird erfindungsgemäss durch einen Ständer mit den Merkmalen des Anspruchs 1 gelöst. Bevorzugte Ausführungsformen sind in den abhängigen Ansprüchen angegeben.

Ein erfindungsgemässer Ständer ist dadurch gekennzeichnet, dass das Fussteil integrale Riegelleisten und das Kopfteil integrale Riegelleisten aufweist, wobei die Riegelleisten das Kopfteil und das Fussteil formschlüssig miteinander verbinden.

Nach der Erfindung ist somit vorgesehen, bei einem mehrteiligen Ständer für Solaranordnungen das vom Fussteil getrennte Kopfteil über Riegelleisten miteinander zu verbinden, die formschlüssig ineinander eingreifen, die also eine Art Verzahnung bilden, wobei die Riegelleisten integral, das heisst einstückig, mit ihrem jeweiligen Teil ausgebildet sind. Die Riegelleisten des Kopfteils sind also einstückig mit dem Kopfteil und die Riegelleisten des Fussteils sind einstückig mit dem Fussteil ausgebildet. Insbesondere sind die Riegelleisten des Fussteils einstückig mit der Grundplatte ausgebildet und/oder die Riegelleisten des Kopfteils einstückig mit dem Auflagebereich. Die integrale Ausführung der Riegelleisten ermöglicht es, die beiden Teile des Ständers, einschliesslich der für die Verbindung der Teile vorgesehenen Elemente, in einem Stranggussverfahren und somit besonders einfach und kostengünstig zu fertigen. Darüber hinaus sind die Riegelleisten aufgrund ihrer integralen Ausgestaltung von Anfang an korrekt positioniert. Eine aufwändige Positionierung bei der Installation, wie sie bei separaten Riegelelementen unter Umständen notwendig ist, ist daher erfindungsgemäss nicht erforderlich. Zugleich kann der Materialaufwand bei der mehrteiligen Ausführung des Ständers besonders gering sein.

Die Riegelleisten können das Kopfteil formschlüssig am Fussteil fixieren. Insbesondere können sie das Kopfteil gegen eine Bewegung senkrecht zur Grundplatte, vom Fussteil hinweg oder/und zum Fussteil hin, sichern. Die Riegelleisten sind vorzugsweise durchgehend ausgebildet, können grundsätzlich aber auch stellenweise unterbrochen sein. Geeigneterweise verlaufen die Riegelleisten parallel zueinander. Insbesondere kann vorgesehen sein, dass sich die Riegelleisten des Fussteils durch das gesamte Fussteil hindurch erstrecken, und/oder dass sich die Riegelleisten des Kopfteils durch das gesamte Kopfteil hindurch erstrecken. Der Formschluss zwischen den Riegelleisten kann an Hinterschnittflächen gebildet sein, die an den Riegelleisten ausgebildet sind.

Bei den Solarpaneelen kann es sich insbesondere um Photovoltaikpaneele handeln. Die Solarpaneele werden von dem Ständer vorzugsweise in einer Winkellage zur Horizontalen abgestützt, insbesondere mit Neigung zur West- oder Ostrichtung hin. Der Ständer kann zumindest ein Solarpaneel abstützen. Vorzugsweise stützt ein erfindungsgemässer Ständer vier Solarpaneele ab, das heisst auf dem Auflagebereich liegen vier Paneele auf. Die Grundplatte kann unmittelbar oder mittelbar auf dem Flachdach aufliegen. Beispielsweise kann zwischen Grundplatte und Flachdach noch eine Bautenschutzmatte, ein Vlies oder auch eine andere Schutz- und/oder Trennlage vorgesehen sein. Ebenso können die Solarpaneele mittelbar, vorzugsweise aber unmittelbar auf dem Auflagebereich aufliegen.

Wie bereits oben erwähnt ist es besonders vorteilhaft, dass das Kopfteil und/oder das Fussteil als Stranggussteile ausgebildet sind. In der Regel weisen solche Stranggussteile herstellungsbedingt einen in Längsrichtung im wesentlichen konstanten Querschnitt auf, mit Ausnahme nachträglich eingebrachter Ausnehmungen.

Besonders bevorzugt ist es, dass das Kopfteil und das Fussteil über eine Schnappverbindung miteinander verbunden sind, welche von Riegelleisten gebildet wird. Unter einer Schnappverbindung kann wie üblich eine Verbindung verstanden werden, die so eingerichtet ist, dass sich das Kopfteil und/oder das Fussteil beim Fügen elastisch verformt und sich die beiden Teile anschließend verhaken. Eine Schnappverbindung ermöglicht eine besonders einfache Installation vor Ort. Insbesondere kann eine Dreh-Schnappverbindung vorgesehen werden, die bei Drehung des Kopfteils relativ zum Fussteil, insbesondere um die Längsachse des Ständers, einschnappt. Hierbei kann zwischen Kopfteil und Fussteil ein Schwenkgelenk gebildet sein.

Eine weitere Ausführungsvariante liegt darin, dass eine Riegelleiste des einen Teils zwischen zwei Riegelleisten des anderen Teils aufgenommen ist. Hierdurch ist eine besonders zuverlässige Verriegelung, auch in gegenüberliegende Richtungen, gegeben. Ferner kann durch diese Anordnung das zuvor erwähnte Schwenkgelenk gebildet sein. Vorzugsweise sind zwei Riegelleisten des einen Teils zwischen jeweils zwei Riegelleisten des anderen Teils aufgenommen. Unter den Teilen wird hier das Kopfteil beziehungsweise das Fussteil verstanden.

Besonders zweckmässig ist es, dass das Kopfteil einen ersten Steg und einen zweiten Steg aufweist und/oder dass das Fussteil einen ersten Steg und einen zweiten Steg aufweist. Vorzugsweise weist jeder der Stege zumindest eine Riegelleiste auf. Die Stege erlauben eine besonders einfache und für den Kraftfluss besonders vorteilhafte Positionierung. Die Stege des Fussteils stehen geeigneterweise aussenseitig vom Fussteil vor und/oder die Stege des Kopfteils stehen geeigneterweise aussenseitig vom Kopfteil vor. Insbesondere können die Stege des Fussteils jeweils eine der Riegelleisten aufweisen und die Stege des Kopfteils jeweils zwei der Riegelleisten.

Bevorzugt kann vorgesehen sein, dass die Riegelleisten des Fussteils einander zugewandt sind und/oder dass die Stege des Kopfteils zwischen die Stege des Fussteils eingreifen. Dies ermöglicht eine besonders einfache und zuverlässige Installation des Kopfteils auf dem am Dach aufstehenden Fussteil.

Eine weitere vorteilhafte Ausgestaltung liegt darin, dass das Kopfteil einen Rohrkörper aufweist. Dies kann im Hinblick auf die Krafteinleitung besonders vorteilhaft sein und der Rohrkörper kann darüber hinaus auch zur Aufnahme von Ballastelementen dienen. Die Längsachse des Rohrkörpers erstreckt sich vorzugsweise in Längsrichtung des Kopfteils, also insbesondere parallel zu den Riegelleisten des Kopfteils.

Geeigneterweise sind die Stege des Kopfteils einerseits und der Auflagebereich für Solarpaneele andererseits auf entgegengesetzten Seiten des Kopfteils angeordnet. Insbesondere kann vorgesehen sein, dass am Rohrkörper einerseits der Auflagebereich für Solarpaneele und andererseits die beiden Stege des Kopfteils angeordnet sind. Hierdurch kann eine besonders kompakte und leicht zu installierende Bauform erhalten werden.

Vorzugsweise kann im Inneren des Rohrkörpers zumindest ein Ballastelement angeordnet werden. In diesem Fall kann das Kopfteil auch zur Positionierung und Sicherung von Ballast dienen, welcher zum Beispiel zur Standfestigkeitserhöhung nicht-dachdurchdringender Solaranordnungen vorgesehen sein kann.

Eine weitere bevorzugte Ausgestaltung der Erfindung liegt darin, dass am Fussteil ein Kanal, insbesondere Schraubkanal, vorgesehen ist, und dass eine Schraube durch das Kopfteil hindurch in den Kanal eingeschraubt ist. Hierdurch ist in besonders einfacher Weise eine zusätzliche Verbindung zwischen Kopfteil und Fussteil gegeben, insbesondere gegenüber einer Verschiebung in Längsrichtung des Ständers. Für eine noch festere Verbindung kann vorzugsweise das Fussteil am Kanal mit dem Kopfteil verrastet sein.

Beispielsweise für eine besonders gute Positionierbarkeit bei der Installation und/oder für eine besonders gute Stabilität kann vorgesehen sein, dass der Ständer über zumindest eine Strebe mit einem weiteren Ständer verbunden ist. Der weitere Ständer kann ebenfalls wie in dieser Anmeldung beschrieben ausgeführt sein. Die Strebe ist bevorzugt am Kopfteil des Ständers und/oder des weiteren Ständers befestigt, was eine übermässige Belastung der Verbindung zwischen Kopfteil und Fussteil verhindern kann. Die Erfindung betrifft auch eine Solaranordnung, welche eine Vielzahl von erfindungsgemässen Ständern aufweist, wobei die Fussteile sämtlicher Ständer der Solaranordnung separate Teile sind. Demgemäss werden die Fussteile also nicht durch eine durchgehende Schiene gebildet, sondern durch separate Teile.

Vorzugsweise ist das Fussteil des Ständers in Längsrichtung des Ständers betrachtet länger als das Kopfteil. Hierdurch wird eine besonders hohe Stabilität bei besonders geringem Materialaufwand erreicht. Unter der Längsrichtung kann insbesondere eine Richtung verstanden werden, in welche die Riegelleisten verlaufen, und/oder die Richtung, in welcher der Ständer im wesentlichen querschnittskonstant ist. Zusätzlich kann das Fussteil des Ständers auch in Querrichtung des Ständers betrachtet, insbesondere parallel zur Grundplatte, breiter sein als das Kopfteil.

Die Erfindung ermöglicht es, Solaranordnungen in besonders einfacher Weise an die lokalen Gegebenheiten anzupassen. So kann durch einfache Variation der Länge der Fussteile berücksichtigt werden, dass unterschiedliche Dachisolierungen unterschiedliche Druckfestigkeiten aufweisen. Durch Variation der Länge der Fussteile kann die lokal benötigte Kontaktfläche zur Übertragung der Drucklasten, zum Beispiel aufgrund von Schnee, realisiert werden, wobei die Länge der Kopfteile vorzugsweise konstant bleiben kann. Hierdurch sind signifikanten Material- bzw. Kosteneinsparungen möglich.

Demgemäss betrifft die Erfindung auch eine Anordnung bestehend aus einer ersten Solaranordnung und einer zweiten Solaranordnung, wobei die erste Solaranordnung und die zweite Solaranordnung auf verschiedenen Flachdächern vorgesehen sind, wobei die beiden Solaranordnungen jeweils Ständer, vorzugsweise mit einem oder mehreren Merkmalen aus diesem Anmeldungstext, zum Abstützen von Solarpaneelen auf dem jeweiligen Flachdach aufweisen, wobei die Ständer jeweils aus einem Kopfteil und einem Fussteil bestehen, wobei die Kopfteile der ersten Solaranordnung dieselben Abmessungen, insbesondere dieselbe Länge aufweisen wie die Kopfteile der zweiten Solaranordnung, und wobei die Fussteile der ersten Solaranordnung andere Abmessungen, insbesondere unterschiedliche Längen aufweisen als die Fussteile der zweiten Solaranordnung. Die Fussteile ein und derselben Anordnung weisen bevorzugt allesamt dieselben Abmessungen auf, was die Installation vereinfacht.

Die Erfindung wird nachfolgend anhand bevorzugter Ausführungsbeispiele näher erläutert, die schematisch in den beiliegenden Figuren dargestellt sind, wobei einzelne Merkmale der nachfolgend gezeigten Ausführungsbeispiele im Rahmen der Erfindung grundsätzlich einzeln oder in beliebiger Kombination realisiert werden können. In den Figuren zeigen schematisch:
- Figur 1:: eine Solarmodulanordnung mit erfindungsgemässen Ständern;
- Figur 2:: eine Querschnittsansicht eines hohen Ständers aus Figur 1 im zusammengefügten Zustand;
- Figur 3:: eine Querschnittsansicht des Ständers aus Figur 2 beim Zusammenfügen;
- Figur 4:: eine Querschnittsansicht eines niedrigen Ständers aus Figur 1 im zusammengefügten Zustand.

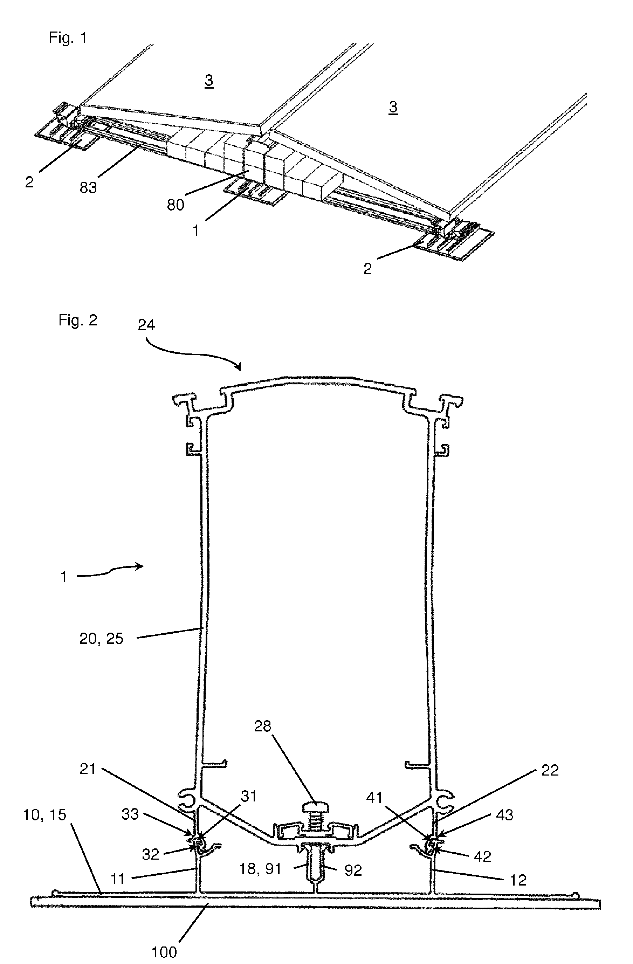

Figur 1 zeigt eine Solarmodulanordnung, die hohe Ständer 1 und niedrige Ständer 2 in alternierender Reihenfolge aufweist. Benachbarte Ständer 1, 2 sind dabei über Streben 83 verbunden. Auf den Ständern 1, 2 liegen Solarpaneele 3 auf, wobei die Solarpaneele 3 aufgrund der alternierenden Reihenfolge von niedrigen Ständern 2 und hohen Ständern 1 umgekehrt V-förmig angeordnet sind.

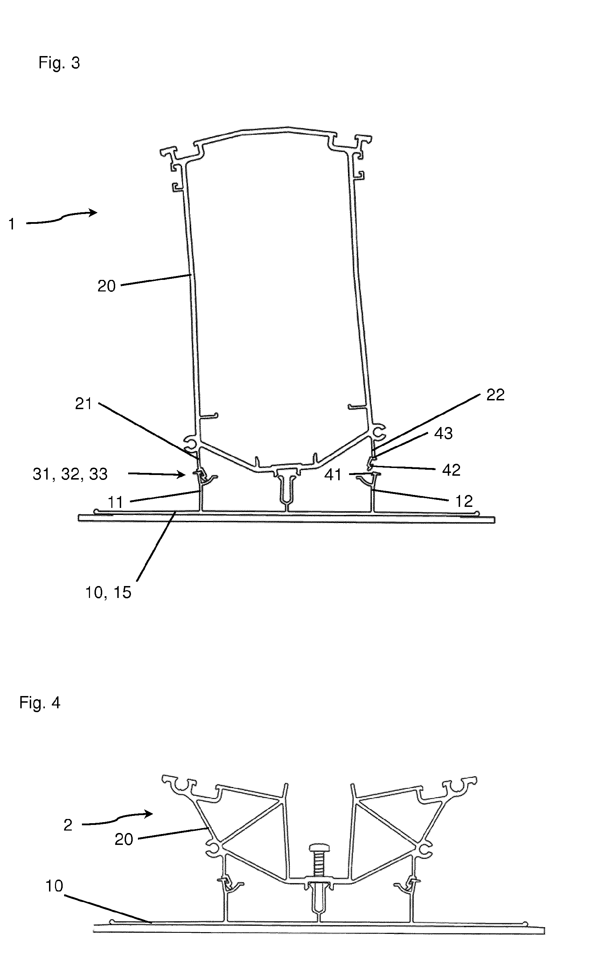

Ein hoher Ständer 1 ist im Detail in den Figuren 2 und 3 dargestellt. Der Ständer 1 weist ein Fussteil 10 zur Auflage auf einem Dach sowie ein Kopfteil 20 auf, auf welches die die Solarpaneele 3 aufgelegt werden.

Das Fussteil 10 weist eine ebene Grundplatte 15 auf, von der zwei Stege 11 und 12 nach oben abstehen. Das Kopfteil 20 weist einen Rohrkörper 25 auf, an dessen Oberseite ein Auflagebereich 24 für Solarpaneele 3 gebildet ist, und an dessen Unterseite zwei Stege 21 und 22 nach unten abstehen. Am Auflagebereich 24 sind auch zwei Sicherungskanäle vorgesehen, in welche Modulklemmen zum Sichern der Solarpaneele 3 eingebracht werden können. Wie Figur 1 zeigt, können im Inneren des Rohrkörpers 25 ein oder mehrere blockförmige Ballastelemente 80, beispielsweise aus Beton, aufgenommen sein. Das Kopfteil 20 und/oder das Fussteil 10 sind vorzugsweise spiegelsymmetrisch ausgeführt.

Der linke Steg 11 des Fussteils 10 weist eine Riegelleiste 31 auf, die vom linken Steg 11 nach rechts zum rechten Steg 12 des Fussteils 10 hin vorsteht. Analog weist der rechte Steg 12 des Fussteils 10 eine Riegelleiste 41 auf, die vom rechten Steg 12 nach links zum linken Steg 11 hin vorsteht.

Der linke Steg 21 des Kopfteils 20 weist zwei übereinander beabstandet zueinander verlaufende Riegelleisten 32 und 33 auf, die auf der dem rechten Steg 22 abgewandten Seite des linken Stegs 21 vorstehen. Analog weist der rechte Steg 22 des Kopfteils 20 zwei übereinander beabstandet zueinander verlaufende Riegelleisten 42 und 43 auf, die auf der dem linken Steg 21 abgewandten Seite des rechten Stegs 22 vorstehen.

Im zusammengefügten Zustand des Ständers 1, der in Figur 2 gezeigt ist, ist die linke Riegelleiste 31 des Fussteils 10 zwischen den beiden linken Riegelleisten 32 und 33 des Kopfteils 20 aufgenommen und ist die rechte Riegelleiste 41 des Fussteils 10 zwischen den beiden rechten Riegelleisten 42 und 43 des Kopfteils 20 aufgenommen. Durch die so verzahnten Riegelleisten sind das Kopfteil 20 und das Fussteil 10 formschlüssig miteinander verbunden. Sämtliche Riegelleisten 31, 32, 33, 41, 42 und 43 verlaufen dabei vorzugsweise parallel zueinander.

Figur 3 zeigt den Ständer 1 aus Figur 2 beim Zusammenfügen. Wie Figur 3 zeigt, können die beiden linken Stege 11 und 21 im Bereich ihrer Riegelleisten 31 beziehungsweise 32 und 33 ein Schwenkgelenk bilden. Um dieses Schwenkgelenk kann das Kopfteil 20 so weit relativ zum Fussteil 10 verschwenkt werden, bis die rechte Riegelleiste 41 des Fussteils 10 unter Deformation des oberen rechten Steges 22 oder/und des unteren rechten Steges 21 zwischen den beiden rechten Riegelleisten 42 und 43 des Kopfteils 20 einschnappt. Die Riegelleisten 31, 32, 33, 41, 42 und 43 bilden somit einen Dreh-Schnappverschluss. Analog können auch - nicht eigens dargestellt - die beiden rechten Stege 12 und 22 im Bereich ihrer Riegelleisten 41 beziehungsweise 42 und 43 ein Schwenkgelenk bilden, um welches das Kopfteil 20 so weit relativ zum Fussteil 10 verschwenkt werden kann, bis die linke Riegelleiste 31 des Fussteils 10 zwischen den beiden linken Riegelleisten 32 und 33 des Kopfteils 20 einschnappt.

Am Fussteil 10, vorzugsweise an der Grundplatte 15 des Fussteils 10, ist ein Kanal 18 vorgesehen, der bevorzugt als Schraubkanal 18 ausgeführt ist. Im zusammengefügten Zustand des Ständers 1, der in Figur 2 dargestellt ist, ist eine Schraube 28, die vorzugsweise als Kopfschraube ausgebildet ist, durch eine Ausnehmung im Kopfteil 20 hindurch in den Kanal 18 eingeschraubt, wodurch das Kopfteil 20 zusätzlich am Fussteil 10 gesichert ist, insbesondere auch gegenüber einer Verschiebung parallel zu den Riegelleisten 31, 32, 33, 41, 42 und 43, das heisst senkrecht zur Zeichenebene in Figur 2. Wie insbesondere Figur 2 weiter zeigt, weist der Kanal 18 zwei parallel verlaufende Schenkel 91 und 92 auf, die im zusammengefügten Zustand des Ständers 1 in das Kopfteil 20 eingreifen, und insbesondere mit dem Kopfteil 20 verrastet sind, wodurch eine weitere Sicherung zwischen Kopfteil 20 und Fussteil 10 gegeben ist. Die in den Kanal 18 eingeschraubte Schraube 28 kann die Verrastung der Schenkel 91 und 92 des Kanals 18 sichern und/oder die Schenkel 91 und 92 nach aussen drücken und dabei gegen das Kopfteil 20 pressen, was eine zusätzliche Sicherung bewirken kann.

Am Fussteil 10 kann auch eine Bautenschutzmatte 100 vorgesehen sein, die auf der Unterseite der Grundplatte 15 angeordnet, vorzugsweise aufgeklebt ist. Zusätzlich oder alternative zur Bautenschutzmatte kann auch ein Vlies oder eine andere Schutz- und/oder Trennlag vorgesehen sein.

In Figur 4 ist der niedrige Ständer 2 aus Figur 1 dargestellt. Das Fussteil 10 dieses niedrigen Ständers 2 ist identisch zum hohen Ständer 1 ausgeführt. Lediglich das Kopfteil 20 des niedrigen Ständers 2 ist verschieden zum hohen Ständer 1 ausgeführt, insbesondere niedriger verglichen mit dem hohen Ständer und mit einem andersartigen Auflagebereich für Solarpaneele. Die Riegelleisten des niedrigen Ständers 2 sind dabei jedoch identisch zum hohen Ständer 1 ausgeführt.

Wie Figur 1 zeigt, sind die jeweiligen Fussteile 10 der Ständer 1 und 2 in Längsrichtung des jeweiligen Ständers betrachtet (das heisst von links vorne nach rechts hinten in Figur 1) länger als die jeweiligen Kopfteile 20. Hierdurch wird eine besonders hohe Standsicherheit bei besonders geringem Materialaufwand erreicht. Wie Figur 1 weiter zeigt, können, insbesondere beiderseits des hohen Ständers 1, Ballastelemente 80 vorgesehen sein, die auf den Streben 83 aufliegen und/oder die im Rohrkörper 25 des Kopfteils 20 des hohen Ständers 1 angeordnet sind.

## Patentansprüche

1. Ständer (1, 2) zum Abstützen von Solarpaneelen (3) auf einem Flachdach, mit einem Fussteil (10), welches eine Grundplatte (15) zur Auflage auf dem Flachdach aufweist, und
einem Kopfteil (20), welches einen Auflagebereich (24) für Solarpaneele (3) aufweist, wobei das Kopfteil (20) und das Fussteil (10) zwei separate Teile sind,
**dadurch gekennzeichnet,**
**dass** das Fussteil (10) integrale Riegelleisten (31, 41) und das Kopfteil (20) integrale Riegelleisten (32, 33, 42, 43) aufweist,
wobei die Riegelleisten (31, 32, 33, 41, 42, 43) das Kopfteil (20) und das Fussteil (10) formschlüssig miteinander verbinden.

2. Ständer (1, 2) nach Anspruch 1,
**dadurch gekennzeichnet,**
**dass** das Kopfteil (20) und das Fussteil (10) als Stranggussteile ausgebildet sind.

3. Ständer (1, 2) nach einem der vorstehenden Ansprüche,
**dadurch gekennzeichnet,**
**dass** das Kopfteil (20) und das Fussteil (10) über eine Schnappverbindung miteinander verbunden sind, welche von Riegelleisten (31, 32, 41, 42) gebildet wird.

4. Ständer (1, 2) nach einem der vorstehenden Ansprüche,
**dadurch gekennzeichnet,**
**dass** eine Riegelleiste (31; 41) des einen Teils (10) zwischen zwei Riegelleisten (32, 33 bzw. 42, 43) des anderen Teils (20) aufgenommen ist.

5. Ständer (1, 2) nach einem der vorstehenden Ansprüche,
**dadurch gekennzeichnet,**
**dass** das Kopfteil (20) einen ersten Steg (21) und einen zweiten Steg (22) aufweist, dass das Fussteil (10) einen ersten Steg (11) und einen zweiten Steg (12) aufweist, und
**dass** jeder der Stege (11, 12, 21, 22) zumindest eine Riegelleiste (31, 32, 33, 41, 42, 43) aufweist.

6. Ständer (1, 2) nach Anspruch 5,
**dadurch gekennzeichnet,**
**dass** die Riegelleisten (31, 42) des Fussteils (10) einander zugewandt sind.

7. Ständer (1, 2) nach Anspruch 5 oder 6,
**dadurch gekennzeichnet,**
**dass** das Kopfteil (20) einen Rohrkörper (25) aufweist, an dem einerseits der Auflagebereich (24) für Solarpaneele (3) angeordnet ist, und an dem andererseits die beiden Stege (21, 22) des Kopfteils (20) angeordnet sind.

8. Ständer (1, 2) nach Anspruch 7,
**dadurch gekennzeichnet,**
**dass** im Inneren des Rohrkörpers (25) zumindest ein Ballastelement (80) angeordnet ist.

9. Ständer (1, 2) nach einem der vorstehenden Ansprüche,
**dadurch gekennzeichnet,**
**dass** am Fussteil (10) ein Kanal (18) vorgesehen ist, und dass eine Schraube (28) durch das Kopfteil (20) hindurch in den Kanal (18) eingeschraubt ist, wobei vorzugsweise das Fussteil (10) am Kanal (18) mit dem Kopfteil (20) verrastet ist.

10. Ständer (1, 2) nach einem der vorstehenden Ansprüche,
**dadurch gekennzeichnet,**
**dass** er über zumindest eine Strebe (83) mit einem weiteren Ständer (1, 2) verbunden ist, wobei die Strebe (83) am Kopfteil (20) befestigt ist.

11. Ständer (1, 2) nach einem der vorstehenden Ansprüche,
**dadurch gekennzeichnet,**
**dass** das Fussteil (10) des Ständers (1, 2) in Längsrichtung des Ständers (1, 2) betrachtet länger ist als das Kopfteil (20).

12. Anordnung bestehend aus einer ersten Solaranordnung und einer zweiten Solaranordnung, wobei die erste Solaranordnung und die zweite Solaranordnung auf verschiedenen Flachdächern vorgesehen sind, wobei die beiden Solaranordnungen jeweils Ständer (1, 2), vorzugsweise nach einem der vorstehenden Ansprüche, zum Abstützen von Solarpaneelen (3) auf dem jeweiligen Flachdach aufweisen, wobei die Ständer (1, 2) jeweils aus einem Kopfteil (20) und einem Fussteil (10) bestehen, wobei die Kopfteile (20) der ersten Solaranordnung dieselben Abmessungen aufweisen wie die Kopfteile (20) der zweiten Solaranordnung, und wobei die Fussteile (10) der ersten Solaranordnung andere Abmessungen aufweisen als die Fussteile (10) der zweiten Solaranordnung.
